# EUROPÄISCHE PATENTANMELDUNG

(11) **EP 0 521 346 A1**
(43) Veröffentlichungstag der Anmeldung: **07.01.1993**
(21) Anmeldenummer: 92110224.0
(22) Anmeldetag: 17.06.1992
(51) Int. Cl.: H05K 13/00

(54) **Vorrichtung zum Speichern und Transportieren von oberflächenempfindlichen Leiterplatten**

(30) Priorität: 05.07.1991 DE 4122272
(71) Anmelder: Löhr & Herrmann GmbH, D-75242 Neuhausen/E. (DE)
(72) Erfinder: Löhr, Hans-Günter, Dr.-Ing., W-7135 Wiernsheim (DE); Herrmann, Gunter, Dr.-Ing., W-7260 Calw (DE); Mozzi, Josef, W-7531 Neuhausen-Hamberg (DE)
(74) Vertreter: Twelmeier, Ulrich, Dipl.Phys.

(57) **Zusammenfassung**

Die Erfindung betrifft eine Vorrichtung zum Speichern und Transportieren von oberflächenempfindlichen Leiterplatten in Form eines Magazins, bestehend aus einem Grundkörper mit Auflagefläche - Stapeltisch - oder Aufstellfläche mit schwach schräggestelltem Rückenteil - Stapelwinkel - zum Auflegen oder -stellen von Leiterplatten als Stapel, wobei jeweils beidseits der Auflagefläche - auch davor - bzw. der Stellfläche mit Rückenteil - auch darüber - in Richtung der Stapelung langlochförmige Bügel angebracht sind, welche Zwischenlagen für die Leiterplatten an Randösen oder -Lochungen derselben von der hängenden Ruhestellung in die liegende oder hängende Arbeitsstellung mit zwischenliegenden Leiterplatten verschieb- und umklappbar geführt aufnehmen.

## Beschreibung

Die Erfindung betrifft eine Vorrichtung zum Speichern und Transportieren von oberflächenempfindlichen Leiterplatten. Leiterplatten werden in der Regel in größeren Stückzahlen gefertigt und müssen mehrere Bearbeitungsschritte auf unterschiedlichen Produktionsmaschinen oder an Handarbeitsplätzen durchlaufen. Zum geordneten Speichern und Transportieren der Leiterplatten zwischen zwei Bearbeitungsvorgängen werden z.B. Transportwagen verwendet, auf denen die Leiterplatten horizontal als Stapel aufgelegt werden oder Magazine, in denen die Leiterplatten in geringer Schräglage stehend gestapelt werden oder auch geschlitzte Wechselpaletten für Leiterplatten mit empfindlichen bzw. klebrigen Oberflächen.

Der Nachteil der bekannten Magazine, in denen die Leiterplatten als Stapel, d.h. sich gegenseitig berührend, gespeichert sind, besteht darin, daß während des Transports bzw. beim Be- und Entladen kleine Relativbewegungen zwischen den aneinanderliegenden Leiterplatten auftreten. Diese führen leicht zu Kratzern oder anderen Beschädigungen an den Leiterbahnen, welche sich auf der Leiterplattenoberfläche befinden. Mit den feiner werdenden Leiterbahnen vergrößert sich diese Beschädigungsgefahr.

Bei den nach der DE-PS 37 17 628 verwendeten, geschlitzten Wechselpaletten werden die Leiterplatten in Schlitze gestellt, so daß sich benachbarte Leiterplatten nicht mehr berühren, was nur für Leiterplatten geeignet ist, die eine ausreichende Steifigkeit besitzen, so daß sie nicht umknicken. Ferner haben diese Paletten einen relativ hohen Platzbedarf, was für die Massenfertigung von Nachteil ist. Für dünne Leiterplatten mit nicht ausreichender Steifigkeit werden Paletten, Transportkörbe oder ähnliches verwendet, in die Leiterplatten hineingelegt und zwischen zwei Leiterplatten z.B. Papier-Zwischenlagen von Hand gelegt. Diese Zwischenlagen sind nach jedem Transport wieder zu entfernen und sind auch nur einmal oder wenige Male verwendbar.

Demgegenüber liegt der Vorrichtung nach der Erfindung die Aufgabe zu Grunde, ein Magazin mit nicht verlierbaren, mehrfach verwendbaren Zwischenlagen zu schaffen. Hierbei dürfen die Zwischenlagen während des Transports nicht verloren gehen . Auch muß eine beliebige Anzahl von Leiterplatten abhängig von der Magazingröße gespeichert werden können und die nicht benötigten Zwischenlagen am Magazin verbleiben und mittransportiert werden, ohne daß dadurch der Transport bzw. das Be- und Entladen des Magazins beeinträchtigt wird.

Diese Aufgaben werden bei der Vorrichtung gemäß Oberbegriff nach Anspruch 1 bei der Erfindung dadurch gelöst, daß jeweils beidseits der Auflagefläche - auch davor - bzw. der Stellfläche mit Rückenteil - auch darüber - in Richtung der Stapelung langlochförmige Bügel angebracht sind, welche Zwischenlagen für die Leiterplatten an Randösen oder -Lochungen derselben von der hängenden Ruhestellung in die liegende oder hängende Arbeitsstellung mit zwischenzulegenden Leiterplatten verschieb- und umklappbar geführt aufnehmen. Die langlochförmig gebogenen Bügel weisen - bei ihrer Befestigungsstelle - Verschlußöffnungen zum Einbringen der Zwischenlagen mit ihren Randösen oder -Lochungen auf. Wenn alle Zwischenlagen, die erforderlich sind, auf die Bügel aufgeschoben sind, wird der Verschluß geschlossen und die Zwischenlagen sind unverlierbar in hängender Ruhelage mit dem Magazin verbunden.

Wird nunmehr eine Leiterplatte in das Magazin eingegeben, wird anschließend von Hand oder maschinell die erste Zwischenlage aus der Vorrats- in die Arbeitsstellung unter Zwischenlage je einer Leiterplatte geklappt, wobei die Bügel die Führung der Zwischenlagen während des Umklappens übernehmen. Weitere Leiterplatten können nacheinander eingegeben werden, wobei nach jeder Leiterplatte eine Zwischenlage umgeklappt wird. Durch die langlochförmige Ausbildung der Bügel ist eine beliebige Anzahl Leiterplatten speicherbar, ohne daß es zu Einschränkungen in der Stapelbildung, z.B. durch Auffedern, kommt. Das Entladen des Magazins erfolgt entspr. umgekehrt wie das Beladen. Die Zwischenlagen bestehen aus einem Geflecht oder Gitter aus flexiblem Material, das für diese Handhabung ausreichend stabil ist, eine weiche Oberfläche aufweist und für Inspektionszwecke durchsichtig ist. Hierfür findet vorwiegend teflonbeschichtetes Glasfasergewebe Verwendung.

Zwei bevorzugte Ausführungen einer Vorrichtung gemäß der Erfindung sind beispielsweise in der Zeichnung dargestellt und nachfolgend beschrieben und zwar zeigen:
- Figur 1: eine perspektivische Ansicht einer ersten Vorrichtung mit einer Zwischenlage,
- Figur 2: eine Seitenansicht des leeren Magazins mit Zwischenlagen in Vorratsstellung,
- Figur 3: den Umklappvorgang einer Zwischenlage beim Befüllen des Magazins und
- Figur 4: ein teilweises beladenes Magazin mit Zwischenlagen.
- Figur 5: eine perspektivische Ansicht einer zweiten Vorrichtung mit Zwischenlagen.

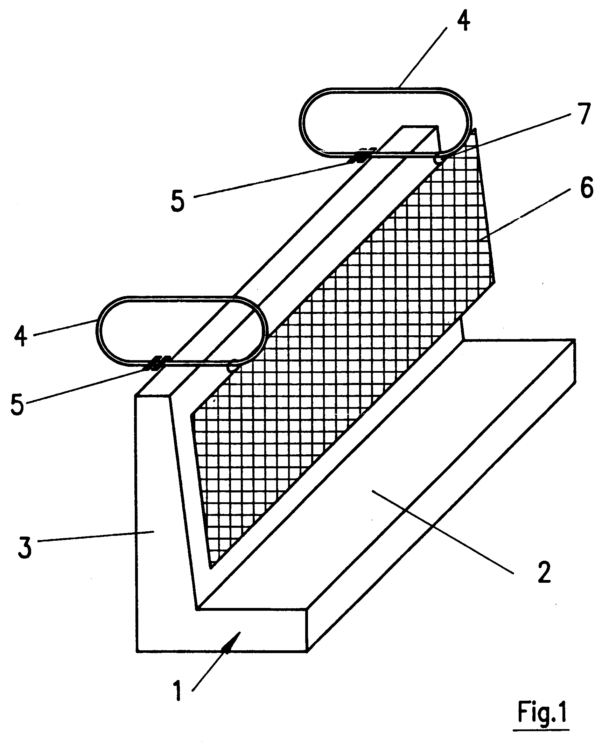

Bei der ersten Ausführung nach Figur 1 besitzt der Grundkörper 1 des Magazins als Winkelanordnung, wie ersichtlich, eine Aufstellfläche 2 und Rückenteil 3 mit schwacher Schrägung. Hier sind auf dem Rückenteil 3 beiodseits langlochförmige Bügel aus glattem Rundmaterial befestigt, die jeweils einen Verschluß 5 zum Einbringen der Zwischenlagen 6 mit Ösen 7 aufweisen. Hier sind die langlochförmigen Bügel 4 liegend angebracht in Richtung der Stapelung.

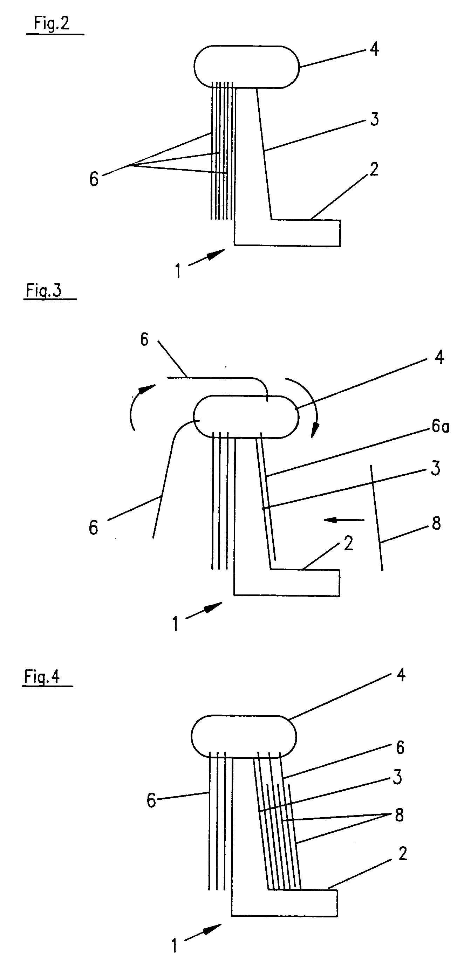

Den Ausgangszustand des leeren Magazins mit mehreren Zwischenlagen 6 zeigt Figur 2. Die Zwischenlagen 6 hängen hier hintereinander aufgereiht auf der dem Rückenteil 3 abgewandten Seite. Demgegenüber zeigt die Figur 3 den Umklappvorgang für die Zwischenlagen 6, ferner eine bereits umgeklappte Zwischenlage 6a und schematisch das Einlegen einer Leiterplatte 8 in das Magazin. Nach Figur 4 ist erkennbar, wie die Zwischenlagen 6 im Wechsel mit den Leiterplatten 8 auf der Aufstellfläche 2 gespeichert werden und nicht benötigte Zwischenlagen auf der abgewandten Seite des Magazin-Rückenteils 3 hängend auf der Vorratsseite verbleiben.

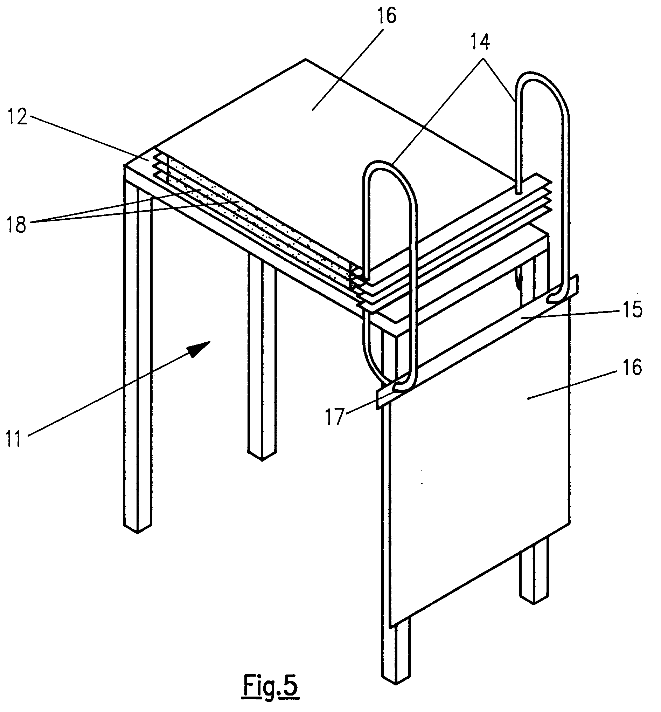

Eine weitere Ausführung zeigt Figur 5; hier besitzt der Grundkörper 11 des Magazins als Tischanordnung, wie ersichtlich, eine Auflagefläche 12. Es sind an derselben (12) beidseits vorne langlochförmige Bügel 14 befestigt mit Verschluß entspr. dem vorhergehenden Beispiel zum Einbringen der Zwischenlagen 16 mit Lochungen 17 an Trägerleisten 15.Hier sind die langlochförmigen Bügel 14 senkrecht stehend angeordnet in Richtung der Stapelung.
Die Zwischenlagen 16 sind hier zunächst hängend angeordnet und werden unter Einbringen von je einer Leiterplatte 18, wie ersichtlich auf die Tischauflage 12 umgelegt.

Im übrigen bestehen die Zwischenlagen als Geflecht oder Gitter aus flexiblem Material mit weicher Oberfläche, insbes. teflonbeschichteten Glasfasergeweben. Soweit besondere Trägerstreifen vorhanden sind, können diese Abstandswulste zu deren Griff aufweisen. Schließlich kann die Überführung der Zwischenlagen von der Vorratsstellung in die Arbeitsstellung jeweils als Zwischenlage für die Leiterplatten bei deren Stapelung auf der Auflage- oder der Aufstellfläche mittels motorgetriebener, parallelgeführter Mitnahmeklemmen zu betätigen sein.

## Patentansprüche

1. Vorrichtung zum Speichern und Transportieren von oberflächenempfindlichen Leiterplatten in Form eines Magazins, bestehend aus einem Grundkörper mit Auflagefläche - Stapeltisch - oder Aufstellfläche mit schwach schräggestelltem Rückenteil - Stapelwinkel - zum Auflegen oder -stellen von Leiterplatten als Stapel,
**dadurch gekennzeichnet,** daß jeweils beidseits der Auflagefläche (12) auch davor - bzw. der Stellfläche (2) mit Rückenteil (3) - auch darüber - in Richtung der Stapelung langlochförmige Bügel (4,14) angebracht sind, welche Zwischenlagen (6,16) für die Leiterplatten (8, 18) an Randösen (/7) oder -Lochungen (17) derselben von der hängenden Ruhestellung in die liegende oder hängende Arbeitsstellung mit zwischenzulegenden Leiterplatten (8,18) verschieb- und umklappbar geführt aufnehmen.

2. Vorrichtung nach Anspruch 1, bei Tischanordnung,
**dadurch gekennzeichnet,** daß die von der hängenden Vorratsseite auf die liegende Arbeitsseite umklappbaren Zwischenlagen (16) beidseits entsprechend der überstehenden, langlochförmigen Bügel (14) geführt sind.

3. Vorrichtung nach Anspruch 1 bei Winkelanordnung,
**dadurch gekennzeichnet,** daß die von der hängenden Vorratsseite auf die hängende Arbeitsseite umklappbaren Zwischenlagen (6) beidseits entsprechend der überstehenden, langlochförmigen Bügeln (4) geführt sind.

4. Vorrichtung nach einem der Ansprüche 1 bis 3,
**dadurch gekennzeichnet,** daß die langlochförmig gebogenen Bügel (4) - bei ihrer Befestigungsstelle - Verschlußöffnungen (5) zum Einbringen der Zwischenlagen (6) mit ihren Randösen (7) oder -Lochungen aufweisen.

5. Vorrichtung nach einem der Ansprüche 1 bis 4,
**dadurch gekennzeichnet,** daß die langlochförmigen Bügel (4,14) aus glattem Rundmaterial bestehen.

6. Vorrichtung nach einem der vorhergehenden Ansprüche,
**dadurch gekennzeichnet,** daß die Überführung der Zwischenlagen (6,16) von der Vorratsstellung in die Arbeitsstellung jeweils als Zwischenlage für die Leiterplatten (8,18) bei deren Stapelung auf der Auflage- (12) oder der Aufstellfläche (2,3) mittels motorgetriebener, parallelgeführter Mitnahmeklemmen zu betätigen ist.

7. Vorrichtung nach einem der vorhergehenden Ansprüche,
**dadurch gekennzeichnet,** daß die Zwischenlagen (6,16) als Geflecht oder Gitter aus flexiblem Material mit weicher Oberfläche, insbes. teflonbeschichteten Glasfasergeweben bestehen.

8. Vorrichtung nach einem der vorhergehenden Ansprüche,
**dadurch gekennzeichnet,** daß die Zwischenlagen (16) mit gelochten (17) Trägerstreifen (15) versehen sind, welche vorzugsweise Abstandswulste zum besseren Eingriff aufweisen.

9. Vorrichtung nach einem der vorhergehenden Ansprüche,
**dadurch gekennzeichnet,** daß die langlochförmigen Bügelführungen (4,14) mit Zwischenlagen (6,16) abnehm- und wechselbar, insbes. mittels Aufsteckspangen montiert sind.
